(19) Europäisches Patentamt
European Patent Office
Office européen des brevets

(11) EP 4 589 492 A1

(12) EUROPEAN PATENT APPLICATION
published in accordance with Art. 153(4) EPC

(43) Date of publication:
23.07.2025 Bulletin 2025/30

(51) International Patent Classification (IPC):
G06N 20/00 (2019.01)    H01M 10/42 (2006.01)
H01M 50/242 (2021.01)

(21) Application number: 23903885.4

(22) Date of filing: 07.12.2023

(52) Cooperative Patent Classification (CPC):
G06N 20/00; H01M 10/42; H01M 50/242;
Y02E 60/10

(86) International application number:
PCT/KR2023/020092

(87) International publication number:
WO 2024/128682 (20.06.2024 Gazette 2024/25)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 13.12.2022 KR 20220174030

(71) Applicant: LG Energy Solution, Ltd.
Seoul 07335 (KR)

(72) Inventor: SONG, Seungho
Daejeon 34122 (KR)

(74) Representative: Goddar, Heinz J.
Boehmert & Boehmert
Anwaltspartnerschaft mbB
Pettenkoferstrasse 22
80336 München (DE)

(54) **METHOD FOR TRAINING ANALYSIS MODEL OF IMPACT ON BATTERY MODULE AND METHOD FOR PREDICTING ANALYSIS RESULT OF IMPACT ON BATTERY MODULE**

(57) A method for learning an analysis model of an impact on a battery module according to one embodiment of the present disclosure includes the steps of: sampling an initial state value of the battery module and a deformed state value of the battery module according to an impact value applied to the battery module; repeating the sampling step during a predetermined test period to acquire learning data; and receiving input of the initial state value of the battery module and the impact value applied to the battery module by the number of times of sampling and machine learning an impact analysis model of a battery module so as to predict an analysis result of the battery module due to an impact.

FIG. 3

**Description**

**[TECHNICAL FIELD]**

Cross Citation with Related Application(s)

This application claims the benefit of Korean Patent Application No. 10-2022-0174030 filed on December 13, 2022 with the Korean Intellectual Property Office, the disclosure of which is incorporated herein by reference in its entirety.

The present disclosure relates to a method for learning an analysis model of an impact on a battery module and a method for predicting an analysis result of the impact on the battery module, and more specifically, to a method for rapidly predicting an impact stability of the battery module by applying a machine learning technique.

**[BACKGROUND]**

Verification of structural safety in specific impact situations is essentially required in the development of battery modules. A method generally used heretofore is to perform a finite element analysis.

Impact analysis results obtained through the finite element analysis are relatively accurate, however, have a disadvantage that modeling and calculations are labor-intensive and time-consuming, and specialized software for structural analysis must be used.

Meanwhile, there are frequent design changes in an early stage of development, and operational inefficiency occurs while repeating this process for each change. In the process of designing and developing a battery module, including the early stage of development of the battery module, a method that can predict the impact stability of the battery module within a rapid time is required.

**[DETAILED DESCRIPTION OF THE INVENTION]**

**[Technical Problem]**

It is an object of the present disclosure to provide a method for predicting a stability of the battery module, particularly a method for rapidly predicting an impact stability of the battery module by applying a machine learning technique.

However, the technical problems to be solved by embodiments of the present disclosure are not limited to the above-described problems, and can be variously expanded within the scope of the technical idea included in the present disclosure.

**[Technical Solution]**

According to one embodiment of the present disclosure, there is provided a method for predicting an analysis result of an impact on a battery module of a battery module evaluation system, comprising an impact analysis model of a battery module, the method comprising the steps of: receiving input of an initial state value of the battery module and an impact value applied to the battery module; and predicting an analysis result of the battery module due to impact from an impact analysis model of the battery module.

The method for predicting an analysis result of an impact on a battery module further comprises learning an analysis model of an impact on a battery module applied to the battery module evaluation system, wherein the learning an analysis model of an impact on a battery module may comprise: sampling an initial state value of the battery module and a deformed state value of the battery module according to an impact value applied to the battery module; repeating the sampling step during a predetermined test period to acquire learning data; and receiving input of the initial state value of the battery module and the impact value applied to the battery module by the number of times of sampling and machine learning an impact analysis model of a battery module so as to predict an analysis result of the battery module due to an impact.

The sampling step may comprise measuring an initial state value of the battery module and storing it; storing an impact value applied to the battery module; and measuring a deformed state value of the battery module due to the impact and storing it.

The step of predicting an analysis result of the battery module may comprise predicting the deformed state value of the battery module due to the impact.

The method for predicting an analysis result of an impact on a battery module may comprise predicting a strain of the battery module from the deformed state value of the battery module.

The initial state value of the battery module may be an initial state value of a predetermined portion of the battery module, and the deformed state value of the battery module may be a deformed state value of a predetermined portion of the battery module.

The strain of the battery module may be a plastic strain of the battery module due to the impact.

The strain of the battery module may be a strain of a predetermined portion of the battery module.

The strain ($\varepsilon_p$) of the battery module is a value obtained by subtracting the elastic strain ($\varepsilon_e$) from the total strain ($\varepsilon$) at the time of impact of the battery module, and follows the following Mathematical Equations 1 to 3,

$$[\text{Mathematical Equation 1}] \quad \varepsilon_p = \varepsilon - \varepsilon_e$$

$$[\text{Mathematical Equation 2}] \quad \varepsilon = \int_{L_0}^{L} \frac{dL}{L} = \ln\left(\frac{L}{L_0}\right)$$

$$[\text{Mathematical Equation 3}] \quad \varepsilon_e = \sigma/E$$

wherein, $L_0$ is a dimension of the battery module before deformation, L is a dimension of the battery module after deformation, $\sigma$ is a stress value when a material is in its elastic limit state, and E is an elastic modulus of the material.

The method for predicting an analysis result of an impact on a battery module may further comprise predicting a SCORE indicating the danger degree of the battery module from the strain of the battery module.

The SCORE indicating the danger degree of the battery module follows the following Mathematical Equation 4,

$$(\text{SCORE}) = 1 / (1 + \text{Exp}(-645.62\varepsilon_p^3 + 312.85\varepsilon_p^2 - \text{-->} 61.417\varepsilon_p + 2.9444)) \qquad [\text{Mathematical Equation 4}]$$

wherein, the SCORE may be a value between 0 and 1.

If the SCORE is less than 0.4, it is determined that the danger degree due to impact of the battery module is "safe", if the SCORE is greater than 0.6, it is determined that the danger degree due to impact of the battery module is "dangerous", and if the SCORE is 0.4 or more and 0.6 or less, determination of the danger degree due to impact of the battery module may be reserved.

The initial state value of the battery module includes an initial value of the dimension of the battery module, and the deformed state value of the battery module may include the dimension value of the battery module after deformation.

The dimension value of the battery module may include at least one of the length, width, height, upper face thickness, lower face thickness, and side face thickness of a predetermined portion of the battery module.

The initial state value of the battery module may include at least one of the density of the battery cells included in the battery module and the mass of the battery cells.

The impact value applied to the battery module may include at least one of an impact size and a duration during which the impact is applied.

According to another embodiment of the present disclosure, there is provided a battery module evaluation system which performs the method for predicting an analysis result of an impact on a battery module, the battery module evaluation system comprising: a data input unit that receives input of an initial state value of the battery module and an impact value applied to the battery module; a data processing unit that executes an impact analysis model of the battery module; and a data output unit that outputs an analysis result of the battery module.

The battery module evaluation system may further comprise a data storage unit that stores an impact analysis model of the battery module.

According to yet another embodiment of the present disclosure, there is provided a method for learning an analysis model of an impact on a battery module, the method comprising the steps of: sampling an initial state value of the battery module and a deformed state value of the battery module according to an impact value applied to the battery module; repeating the sampling step during a predetermined test period to acquire learning data; and receiving input of the initial state value of the battery module and the impact value applied to the battery module by the number of times of sampling and machine learning an impact analysis model of a battery module so as to predict an analysis result of the battery module due to an impact.

The sampling step may comprise measuring an initial state value of the battery module and storing it; storing an impact value applied to the battery module; and measuring a deformed state value of the battery module due to the impact and storing it.

The initial state value of the battery module may be an initial state value of a predetermined portion of the battery module, and the deformed state value of the battery module may be a deformed state value of a predetermined portion of the battery module.

The machine learning step may comprise calculating a strain of the battery module from the deformed state value of the battery module and storing it.

The strain of the battery module may be a plastic strain of the battery module due to the impact.

The strain of the battery module may be a strain of a predetermined portion of the battery module.

The strain ($\varepsilon_p$) of the battery module is a value obtained by subtracting the elastic strain ($\varepsilon_e$) from the total strain ($\varepsilon$) at the time of impact of the battery module, and follows the following Mathematical Equations 1 to 3,

$$[\text{Mathematical Equation 1}] \quad \varepsilon_p = \varepsilon - \varepsilon_e$$

$$[\text{Mathematical Equation 2}] \quad \varepsilon = \int_{L_0}^{L} \frac{dL}{L} = \ln\left(\frac{L}{L_0}\right)$$

$$[\text{Mathematical Equation 3}] \quad \varepsilon_e = \sigma/E$$

wherein, $L_0$ is a dimension of the battery module before deformation, $L$ is a dimension of the battery module after deformation, $\sigma$ is a stress value when the material of the battery module is in its elastic limit state, and $E$ is an elastic modulus of the material of the battery module.

The machine learning step may further comprise calculating a SCORE indicating the danger degree of the battery module from the strain of the battery module and storing it.

The SCORE indicating the danger degree of the battery module may follow the following Mathematical Equation 4,

$$(\text{SCORE}) = 1 / (1 + \text{Exp}(-645.62\varepsilon_p^3 + 312.85\varepsilon_p^2 - 61.417\varepsilon_p + 2.9444)) \qquad [\text{Mathematical Equation 4}]$$

wherein, the SCORE may be a value between 0 and 1.

If the SCORE is less than 0.4, it is determined that the danger degree due to impact of the battery module is "safe", if the SCORE is greater than 0.6, it is determined that the danger degree due to impact of the battery module is "dangerous", and if the SCORE is 0.4 or more and 0.6 or less, determination of the danger degree due to impact of the battery module may be reserved.

The initial state value of the battery module may include an initial value of the dimension of the battery module, and the deformed state value of the battery module may include the dimension value of the battery module after deformation.

The dimension value of the battery module may include at least one of the length, width, height, upper face thickness, lower face thickness, and side face thickness of a predetermined portion of the battery module.

The initial state value of the battery module may include at least one of the density of the battery cells included in the battery module and the mass of the battery cells.

The impact value applied to the battery module may include at least one of an impact size and a duration during which the impact is applied.

The impact size may be expressed by the acceleration of the object that applies impact to the battery module.

The method for learning an analysis model of an impact on a battery module may further comprise verifying effectiveness of the impact analysis of the battery module, wherein the verifying effectiveness comprises: generating, as verification data, an initial state value of the battery module and a deformed state value of the battery module according to an impact value applied to the battery module during a predetermined verification period; calculating an analysis result of the battery module from an impact analysis model of the battery module using the verification data; calculating an analysis result of the battery module according to the initial state value of the battery module and the impact value applied to the battery module using the verification data through finite element analysis; and determining that the impact analysis model of the battery module is valid, when the difference between the analysis result of the battery module predicted from the impact analysis model of the battery module and the analysis result of the battery module calculated through the finite element analysis is within a predetermined reference value range.

**[Advantageous Effects]**

According to the present disclosure, it is possible to rapidly predict the impact stability of the battery module, and as a result, the design and development of the electrode module can be carried out efficiently.

In addition, conditions and prediction results for the impact stability of the battery module can be standardized. Thereby, the reliability in quality of the manufactured battery module can be ensured.

Effects obtainable from the present disclosure are not limited to the effects mentioned above, and additional other effects not mentioned herein will be clearly understood from the description of the appended claims by those skilled in the art.

**[BRIEF DESCRIPTION OF THE DRAWINGS]**

FIG. 1 is a block diagram illustrating a battery module evaluation system 100 according to an embodiment of the present disclosure.

FIG. 2 is a flowchart illustrating a method of learning an impact analysis model of a battery module performed in the battery module evaluation system 100 according to an embodiment of the present disclosure.

FIG. 3 is a flowchart illustrating a method for predicting an analysis result of the impact on a battery module performed by the battery module evaluation system 100 including an impact analysis model of the battery module according to an embodiment of the present disclosure.

FIG. 4 is an analysis result of the impact on a battery module according to an embodiment of the present disclosure, and graphically shows the SCORE calculated according to the strain of the battery module.

**[DETAILED DESCRIPTION OF THE EMBODIMENTS]**

Hereinafter, embodiments disclosed in the present specification will be described in detail with reference to the accompanying drawings, however, identical or similar elements are assigned identical reference numerals regardless of reference numerals, and a redundant description thereof will be omitted.

The suffixes "module" and/or "part" of elements used in the description below are assigned or used only in consideration of the ease of description of the specification, and the suffixes themselves do not have meanings or roles distinguished from each other. In addition, a term such as "... part", "... unit", and "module" described in the specification means a unit for performing at least one function or operation, which can be embodied by hardware, by software, or by a combination of hardware and software.

In the following description of the present disclosure, a detailed description of known functions and configurations incorporated herein will be omitted when it may make the subject matter of the present disclosure unclear. In addition, the accompanying drawings are only for easy understanding of the embodiments disclosed in the present specification, however, the technical idea disclosed herein is not limited by the accompanying drawings and should be construed as including all changes, equivalents and substitutes included in the spirit and scope of the present disclosure.

In this specification, terms such as "include" or "have" are intended to designate that the features, numbers, steps, operations, components, parts, or combinations thereof described in the specification exist, but it should be understood that this does not preclude the existence or addition of one or more other features, numbers, steps, operations, components, parts, or combinations thereof.

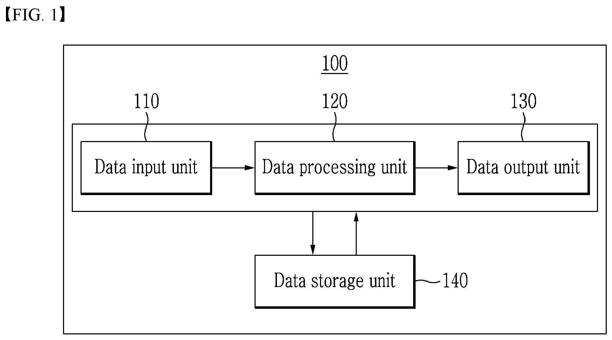

FIG. 1 is a block diagram illustrating a battery module evaluation system 100 according to an embodiment of the present disclosure. The battery module evaluation system 100 according to an embodiment of the present disclosure includes a data input unit 110, a data processing unit 120, and a data output unit 130.

The data input unit 110 may be, for example, an input device of a mobile device, an input device of a computer, various keyboards, a mouse, an electronic pen, a microphone, etc. and suffices if it is a unit that can receive input of other data.

The data processing unit 120 receives input of learning data, and performs machine learning on an impact analysis model of the battery module according to an embodiment of the present disclosure, while in predicting the analysis result of the impact on the battery module, it can receive input of the initial state value of the battery module and the impact value applied to the module, and predict the analysis result of the impact on the battery module using the impact analysis model of the battery module. The data processing unit 120 may be, for example, a processor of a mobile device, a processor of a computer, and the like, and suffices if it is a device capable of performing the method for learning an analysis model of the impact on a battery module and the method for predicting the analysis result of the impact on the battery module according to an embodiment of the present disclosure.

The data output unit 130 outputs the results processed by the data processing unit 120. For example, it may be an output device of a mobile device, an output device of a computer, various display devices, various speaker units, and the like, and suffices if it is a unit that can output other data.

The data storage unit 140 can store the impact analysis model for the battery module according to an embodiment of the present disclosure, and also store learning data, data input to the data input unit 110, processing results in the data processing unit 120, other various data, and the like.

The data input unit 110, the data processing unit 120, the data output unit 130, and the data storage unit 140 may all be integrated into one device, and in some cases, at least one of the data input unit 110, the data processing unit 120, the data output unit 130, and the data storage unit 140 may be remotely connected to and controlled by other components.

The analysis model of an impact on a battery module according to an embodiment of the present disclosure can be acquired through machine learning.

First, a method for learning an analysis model of an impact on a battery module will be described.

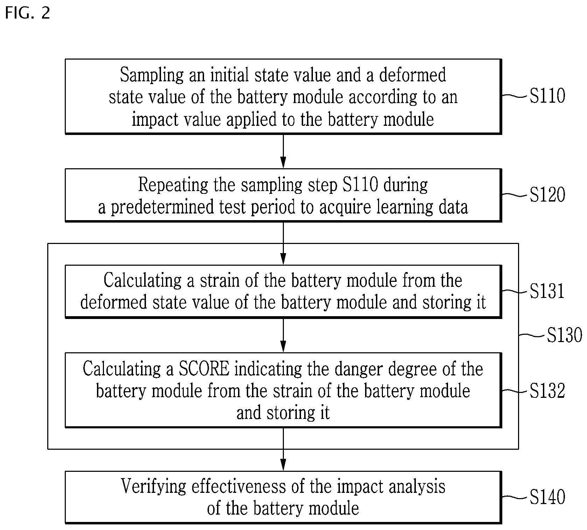

FIG. 2 is a flowchart illustrating a method of learning an analysis model of an impact on a battery module performed in the battery module evaluation system 100 according to an embodiment of the present disclosure.

First, the data processing unit 120 performs a step S110 of sampling an initial state value of the battery module and the deformed state value of the battery module according to an impact value applied to the battery module. In step S110, the data input unit 110 receives input of the initial state value of the battery module and the impact value applied to the battery module, and the data processing unit 120 performs step S110.

Further, the data sampled in step S110 is stored in the data storage unit 140. More specifically, it comprises a step (S111) of measuring an initial state value of the battery module and storing it in the data storage unit 140; a step (S112) of applying an impact to the battery module and storing the impact value applied to the battery module in the data storage unit 140; and a step (S113) of measuring a deformed state value of the battery module due to the impact and storing it in the data storage unit 140.

Here, the initial state value of the battery module means the initial state value of a predetermined portion of the battery module. The predetermined portion of the battery module may be a portion of the battery module that is prespecified (preset) as desired by an operator in accordance with the process, environment, and the like. This is because, when an impact is applied to the battery module, the dimensions and other conditions of the battery module may be deformed mainly in the area where the impact is applied. However, the present disclosure is not limited to those set forth above, and a predetermined portion of the battery module may be the entire battery module. Further, the initial state value of the battery module includes the initial dimension value of the battery module. The deformed state value of the battery module due to impact means the deformed state value of a predetermined portion of the battery module. In addition, the deformed state of a predetermined portion of the battery module includes a dimension value in which the initial dimension has been deformed due to an impact applied to the battery module.

The dimension value of the battery module means the dimension value of a predetermined portion of the battery module. The dimension value of the battery module (i.e., the dimension value of a predetermined portion of the battery module) includes at least one of the length, width, height, upper face thickness, lower face thickness, and side face thickness of a predetermined portion of the battery module. With regard to detailed factors included in the dimension values of the battery module, the present disclosure is not limited to those set forth above, and the factors can be set in various ways in accordance with the environment in which the invention is embodied or the conditions required by an operator.

For example, the total length, width and height of the battery module may be set as the dimension values of the battery module, however, if the battery module consists of a U frame and a top plate that covers it, various variations and changes can be made, such as being able to set the length, width and height of the U frame alone as the dimension values of the battery module, and being able to set the length, width and height of the top plate alone as the dimension values of the battery module. In addition, it is possible to take into account only the dimension values for the frame or plate, focusing on the portion where impact is applied.

Further, the initial state value of the battery module includes at least one of the density of the battery cells included in the battery module and the mass of the battery cells.

The impact value applied to the battery module includes at least one of an impact size and a duration during which the impact is applied. An example of factors (physical quantities) representing the impact size includes the acceleration of the object that impacts the battery module. However, the present disclosure is not limited to those set forth above, and the impact of the battery module can be analyzed by selecting various physical quantities indicating the impact size so as to match with the environment in which the invention is embodied or the conditions required by an operator.

The deformed status value of the battery module due to impact may be status information such as temperature change, ignition, explosion, and the like of the battery module, depending on the case.

The data processing unit 120 repeats the sampling step (S110) for a predetermined test period to acquire learning data (S 120). In step S120, similarly, the data input unit 11 receives input of the initial state value of the battery module and the impact value applied to the battery module, and the data processing unit 120 performs step S120. Further, the learning data acquired in step S120 is stored in the data storage unit 140.

The data processing unit 120 receives input of the initial state value of the battery module and the impact value applied to the battery module by the number of times of sampling and performs a step (S130) of machine learning an impact analysis model of a battery module so as to predict an analysis result of the battery module due to an impact.

Step S130 includes a step (S131) of calculating the strain of the battery module from the deformed state value of the battery module through the data processing unit 120 and storing it in the data storage unit 140.

At this time, the strain of the battery module refers to the strain of a predetermined portion of the battery module. For predetermined portions of the battery module, refer to the portions set forth above.

Further, the strain of the battery module means a plastic strain ($\varepsilon_p$) of the battery module due to the impact. The strain ($\varepsilon_p$) of the battery module is a value obtained by subtracting the elastic strain ($\varepsilon_e$) from the total strain ($\varepsilon$) at the time of impact of the battery module, and follows the following Mathematical Equations 1 to 3,

$$[\text{Mathematical Equation 1}] \quad \varepsilon_p = \varepsilon - \varepsilon_e$$

$$[\text{Mathematical Equation 2}] \quad \varepsilon = \int_{L_0}^{L} \frac{dL}{L} = \ln\left(\frac{L}{L_0}\right)$$

$$[\text{Mathematical Equation 3}] \quad \varepsilon_e = \sigma/E$$

wherein, $L_0$ is a dimension of the battery module before deformation (i.e., the dimension of a predetermined portion of the battery module before deformation), $L$ is a dimension of the battery module after deformation (i.e., the dimension of a predetermined portion of the battery module after deformation). Further, $\sigma$ is a stress value when the material (material of the battery module, i.e. material of a predetermined portion of the battery module) is in its elastic limit state, and $E$ is the elastic modulus of the material. When a material (material of the battery module, i.e. material of a predetermined portion of the battery module) is in a deformation that does not exceed its elastic limit, stress and strain have a linear relationship with each other, and the slope is called the elastic modulus. Each of $\sigma$ and E is a value unique to the battery module to be inspected (i.e., the material of the battery module) and is input as a preset value. Alternatively, the elastic strain ($\varepsilon_e$) derived from Mathematical Equation 3 is also a unique value for the battery module to be inspected (i.e., the material of the battery module), so that the elastic strain ($\varepsilon_e$) is input as a preset value. As described above, the dimension of the battery module includes at least one of the length, width, height, upper face thickness, lower face thickness, and side face thickness of a predetermined portion of the battery module.

The strain ($\varepsilon_p$) of each battery module is derived by applying Mathematical Equation 1 to Mathematical Equation 3 to each factor of length, width, height, upper face thickness, lower face thickness, and side face thickness of a predetermined portion of the battery module, and then the average value of the strain ($\varepsilon_p$) of each battery module derived for each factor of the length, width, height, upper face thickness, lower face thickness and side face thickness of a predetermined portion of the battery module may be determined, or alternatively, the maximum value may be determined among the strain ($\varepsilon_p$) of each battery module.

Alternatively, in some cases, only some factors suitable for the environment are selected from among the length, width, height, upper face thickness, lower face thickness and side face thickness of a predetermined portion of the battery module to derive the strain ($\varepsilon_p$) of the battery module, respectively. Similarly, the average value of the strain ($\varepsilon_p$) of each battery module may be determined, or the maximum value may be determined.

Further, step S130 further comprises a step (S132) of calculating a SCORE indicating the danger degree of the battery module from the strain of the battery module calculated in step S131.

For example, the SCORE indicating the danger degree of a battery module follows the following Mathematical Equation 4.

[Mathematical Equation 4] (SCORE) = 1 / (1 + Exp(-645.62$\varepsilon_p^3$ + 312.85$\varepsilon_p^2$ - 61.417$\varepsilon_p$ + 2.9444))

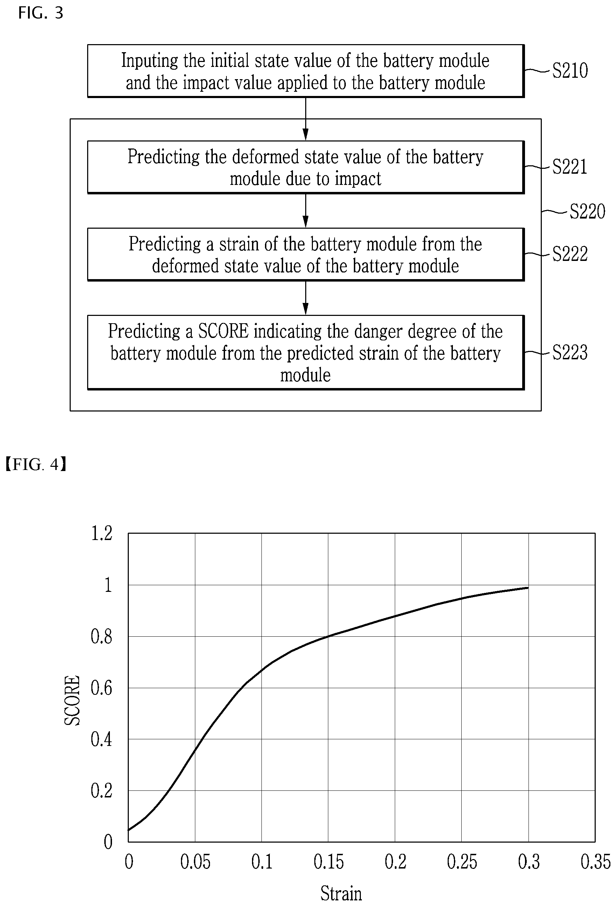

This is a value obtained by arbitrarily scaling the plastic strain ($\varepsilon_p$) of the battery module so that when 0 $\leq$ the plastic strain ($\varepsilon_p$) of the battery module $\leq$ 1, the SCORE is a value between 0 and 1 (see FIG. 4).

Mathematical Equation 4 is an example, and the present disclosure is not limited to those set forth above. The SCORE can be adjusted in accordance with the various environments in which the invention is embodied.

$$[\text{Mathematical Equation 5}] \quad (\text{SCORE}) = 1 / \left(1 + \text{Exp}\left(C_1\varepsilon_p^3 + C_2\varepsilon_p^2 + C_3\varepsilon_p + C_4\right)\right)$$

wherein, $C_1$, $C_2$, $C_3$, $C_4$ are coefficients.

Further, this can be classified into grades according to the SCORE calculated in step S132.

For example, if the SCORE is less than 0.4, it is determined that the danger degree due to impact of the battery module is "safe"; if the SCORE is greater than 0.6, it is determined that the danger degree due to impact of the battery module is "dangerous"; and if the SCORE is 0.4 or more and 0.6 or less, determination of the danger degree due to impact of the battery module may be reserved. This is an example, and the present disclosure is not limited to those set forth above.

For example, the grade of danger degree may be classified into a different number of grades instead of the three mentioned above, and the range in which the SCORE calculated according to the coefficient value set in Mathematical Equation 5 is scaled also differs. Therefore, various changes and variations can be made, for example, the standard value for dividing grades may be a value other than 0.4 and 0.6 mentioned above.

Further, the data processing unit 120 performs a step (S140) of verifying the effectiveness of the impact analysis of the battery module.

Step S140 comprises a step (S141) of generating, as verification data, an initial state value of the battery module and a deformed state value of the battery module according to an impact value applied to the battery module during a predetermined verification period; a step (S142) of calculating an analysis result of the battery module from an impact analysis model of the battery module using the verification data; a step (S143) of calculating an analysis result of the battery module according to the initial state value of the battery module and the impact value applied to the battery module using the verification data through finite element analysis; and a step (S144) of determining that the impact analysis model of the battery module is valid, when the difference between the analysis result of the battery module predicted from the impact analysis model of the battery module and the analysis result of the battery module calculated through the finite element analysis is within a predetermined reference value range.

FIG. 3 is a flowchart illustrating a method for predicting an analysis result of the impact on a battery module performed by the battery module evaluation system 100 including an impact analysis model of the battery module according to an embodiment of the present disclosure.

The battery module evaluation system 100 performs the method for learning an analysis model of an impact on a battery module described above with reference to FIG. 2. The analysis model of an impact on a battery module may be acquired through machine learning in the data processing unit 120 and stored in the data storage unit 140. The battery module evaluation system 100 predicts an analysis result of the impact on the battery module through a machine-learned impact analysis model of the battery module according to an embodiment of the present disclosure.

First, the data processing unit 120 performs a step (S210) of receiving input of the initial state value of the battery module and the impact value applied to the battery module.

Here, the initial state value of the battery module includes the initial dimension value of the battery module. The initial dimension value of the battery module includes at least one of the length, width, height, upper face thickness, lower face thickness, and side face thickness of a predetermined portion of the battery module. Further, the initial state value of the battery module includes at least one of the density of the battery cells included in the battery module and the mass of the battery cells. The impact value applied to the battery module includes at least one of the impact size and the duration during which the impact is applied.

A step (S220) of predicting the analysis results of the impact on the battery module from the impact analysis model of the battery module is performed.

Step S220 includes a step (S221) of predicting a deformed state value of the battery module due to impact. Here, the deformed state value of the battery module due to the impact includes the dimension value where the initial dimension is deformed due to the impact applied to the battery module. The deformed dimension value of the battery module, that is, the dimension of the battery module after deformation, includes at least one of the length, width, height, upper face thickness, lower face thickness, and side face thickness of a predetermined portion of the battery module. The deformed state value of the battery module due to impact may be state information such as temperature change, ignition, or explosion of the battery module, depending on the case.

Further, step S220 includes a step (S222) of predicting the strain of the battery module from the deformed state value of the battery module predicted in step S221.

At this time, the strain of the battery module means a plastic strain ($\varepsilon_p$) of the battery module due to impact. The strain ($\varepsilon_p$) of the battery module is a value obtained by subtracting the elastic strain ($\varepsilon_p$) from the total strain ($\varepsilon$) at the time of impact of the battery module, and follows the following Mathematical Equations 1 to 3,

$$[\text{Mathematical Equation 1}] \quad \varepsilon_p = \varepsilon - \varepsilon_e$$

$$[\text{Mathematical Equation 2}] \quad \varepsilon = \int_{L_0}^{L} \frac{dL}{L} = \ln\left(\frac{L}{L_0}\right)$$

$$[\text{Mathematical Equation 3}] \quad \varepsilon_e = \sigma/E$$

wherein, $L_0$ is a dimension of the battery module before deformation, and $L$ is a dimension of the battery module after deformation. The dimensions of the battery module include at least one of the length, width, height, upper face thickness, lower face thickness, and side face thickness of a predetermined portion of the battery module as described above. The dimension of the battery module can be set by deforming and changing in various ways. Refer to those set forth above with reference to FIG. 2.

The strain $(\varepsilon_p)$ of each battery module is derived by applying Mathematical Equation 1 to Mathematical Equation 3 to each factor of length, width, height, upper face thickness, lower face thickness, and side face thickness of a predetermined portion of the battery module, and then the average value of the strain $(\varepsilon_p)$ of each battery module derived for each factor of the length, width, height, upper face thickness, lower face thickness and side face thickness of a predetermined portion of the battery module may be obtained, or alternatively, the maximum value may be obtained among the strain $(\varepsilon_p)$ of each battery module.

Alternatively, in some cases, only some factors suitable for the environment are selected from among the length, width, height, upper face thickness, lower face thickness and side face thickness of a predetermined portion of the battery module to derive the strain $(\varepsilon_p)$ of the battery module, respectively. Similarly, the average value of the strain $(\varepsilon_p)$ of each battery module may be determined, or the maximum value may be determined.

Further, step S220 further comprises a step (S223) of calculating a SCORE indicating the danger degree of the battery module from the strain of the battery module predicted in step S222.

For example, the SCORE indicating the danger degree of a battery module follows the following Mathematical Equation 4.

$$(SCORE) = 1 / (1 + Exp(-645.62\varepsilon_p{}^3 + 312.85\varepsilon_p{}^2 - 61.417\varepsilon_p + 2.9444)) \qquad \text{[Mathematical Equation 4]}$$

This is a value obtained by arbitrarily scaling the plastic strain $(\varepsilon_p)$ of the battery module so that when $0 \leq$ the plastic strain $(\varepsilon_p)$ of the battery module $\leq 1$, the SCORE is a value between 0 and 1 (see FIG. 4).

Mathematical Equation 4 is an example, and the present disclosure is not limited to those set forth above. The SCORE can be adjusted in accordance with the various environments in which the invention is embodied.

$$[\text{Mathematical Equation 5}] \quad (SCORE) = 1 / \left(1 + \exp\left(C_1\varepsilon_p{}^3 + C_2\varepsilon_p{}^2 + C_3\varepsilon_p + C_4\right)\right)$$

wherein, $C_1$, $C_2$, $C_3$, $C_4$ are coefficients.

Further, this can be classified into grades according to the SCORE calculated in step S132.

For example, if the SCORE is less than 0.4, it is determined that the danger degree due to impact of the battery module is "safe"; if the SCORE is greater than 0.6, it is determined that the danger degree due to impact of the battery module is "dangerous"; and if the SCORE is 0.4 or more and 0.6 or less, determination of the danger degree due to impact of the battery module may be reserved. This is an example, and the present disclosure is not limited to those set forth above.

For example, the grade of danger degree may be classified into a different number of grades instead of the three mentioned above, and the range in which the SCORE calculated according to the coefficient value set in Mathematical Equation 5 is scaled also differs. Therefore, various changes and variations can be made, for example, the standard value for dividing grades may be a value other than 0.4 and 0.6 mentioned above.

The method of predicting the analysis result of the impact on the battery module using the impact analysis model of the battery module according to the present disclosure shows a matching rate of about 90% or more compared to the conventional finite element analysis technique. On the other hand, it is possible to rapidly predict the impact stability of the battery module relative to the conventional technique, and as a result, the design and development of the electrode module can be carried out efficiently. In addition, it makes it possible to standardize the conditions and prediction results for the impact stability of the battery module. Accordingly, reliability of the quality of the manufactured battery modules can be ensured.

Although the invention has been described in detail above with reference to preferred embodiments thereof, it will be appreciated by those skilled in the art that the scope of the present disclosure is not limited thereto, and various modifications and improvements can be made in these embodiment without departing from the principles and sprit of the invention, the scope of which is defined in the appended claims and their equivalents. For example, the method for learning an analysis model of an impact on a battery module and the method for predicting an analysis result of the impact on the battery module according to the present disclosure can be applied not only to battery modules, but also to battery cells, battery cell stacks, or battery packs.

[Description of Reference Numerals]

100: battery module evaluation system

110:    data input unit
120:    data processing unit
130:    data output unit
140:    data storage unit

**Claims**

1.  A method for predicting an analysis result of an impact on a battery module of a battery module evaluation system, comprising an impact analysis model of a battery module, the method comprising the steps of:

    receiving input of an initial state value of the battery module and an impact value applied to the battery module; and
    predicting an analysis result of the battery module due to impact from an impact analysis model of the battery module.

2.  The method for predicting an analysis result of an impact on a battery module according to claim 1,

    further comprising learning an analysis model of an impact on a battery module applied to the battery module evaluation system,
    wherein the learning an analysis model of an impact on a battery module comprises:

    sampling an initial state value of the battery module and a deformed state value of the battery module according to an impact value applied to the battery module;
    repeating the sampling step during a predetermined test period to acquire learning data; and
    receiving input of the initial state value of the battery module and the impact value applied to the battery module by the number of times of sampling and machine learning an impact analysis model of a battery module so as to predict an analysis result of the battery module due to an impact.

3.  The method for predicting an analysis result of an impact on a battery module according to claim 2, wherein:
    the sampling step comprises:

    measuring an initial state value of the battery module and storing it;
    storing an impact value applied to the battery module; and
    measuring a deformed state value of the battery module due to the impact and storing it.

4.  The method for predicting an analysis result of an impact on a battery module according to claim 1, wherein:
    the predicting an analysis result of the battery module comprises predicting the deformed state value of the battery module due to the impact.

5.  The method for predicting an analysis result of an impact on a battery module according to claim 4,
    comprising predicting a strain of the battery module from the deformed state value of the battery module.

6.  The method for predicting an analysis result of an impact on a battery module according to claim 1, wherein:
    the initial state value of the battery module is an initial state value of a predetermined portion of the battery module, and
    the deformed state value of the battery module is a deformed state value of a predetermined portion of the battery module.

7.  The method for predicting an analysis result of an impact on a battery module according to claim 1, wherein:
    the strain of the battery module is a plastic strain of the battery module due to the impact.

8.  The method for predicting an analysis result of an impact on a battery module according to claim 5, wherein:
    the strain of the battery module is a strain of a predetermined portion of the battery module.

9.  The method for predicting an analysis result of an impact on a battery module according to claim 7, wherein:

    the strain ($\varepsilon_p$) of the battery module is a value obtained by subtracting the elastic strain ($\varepsilon_e$) from the total strain ($\varepsilon$) at the time of impact of the battery module, and follows the following Mathematical Equations 1 to 3,

[Mathematical Equation 1] $\varepsilon_p = \varepsilon - \varepsilon_e$

[Mathematical Equation 2] $\varepsilon = \int_{L_0}^{L} \frac{dL}{L} = \ln\left(\frac{L}{L_0}\right)$

[Mathematical Equation 3] $\varepsilon_e = \sigma/E$

wherein, $L_0$ is a dimension of the battery module before deformation, $L$ is a dimension of the battery module after deformation, $\sigma$ is a stress value when a material is in its elastic limit state, and E is an elastic modulus of the material.

10. The method for predicting an analysis result of an impact on a battery module according to claim 5, further comprising predicting a SCORE indicating the danger degree of the battery module from the strain of the battery module.

11. The method for predicting an analysis result of an impact on a battery module according to claim 10, wherein:

the SCORE indicating the danger degree of the battery module follows the following Mathematical Equation 4,

(SCORE) = 1 / (1 + Exp(-645.62$\varepsilon_p{}^3$ + 312.85$\varepsilon_p{}^2$ - 61.417$\varepsilon_p$ + 2.9444))         [Mathematical Equation 4]

wherein, the SCORE is a value between 0 and 1.

12. The method for predicting an analysis result of an impact on a battery module according to claim 11, wherein:

if the SCORE is less than 0.4, it is determined that the danger degree due to impact of the battery module is "safe", if the SCORE is greater than 0.6, it is determined that the danger degree due to impact of the battery module is "dangerous", and if the SCORE is 0.4 or more and 0.6 or less, determination of the danger degree due to impact of the battery module is reserved.

13. The method for predicting an analysis result of an impact on a battery module according to claim 1, wherein:

the initial state value of the battery module includes an initial value of the dimension of the battery module, and the deformed state value of the battery module includes the dimension value of the battery module after deformation.

14. The method for predicting an analysis result of an impact on a battery module according to claim 13, wherein: the dimension value of the battery module includes at least one of the length, width, height, upper face thickness, lower face thickness, and side face thickness of a predetermined portion of the battery module.

15. The method for predicting an analysis result of an impact on a battery module according to claim 1, wherein: the initial state value of the battery module includes at least one of the density of the battery cells included in the battery module and the mass of the battery cells.

16. The method for predicting an analysis result of an impact on a battery module according to claim 1, wherein: the impact value applied to the battery module includes at least one of an impact size and a duration during which the impact is applied.

17. A battery module evaluation system which performs the method for predicting an analysis result of an impact on a battery module according to claim 1, the battery module evaluation system comprising:

a data input unit that receives input of an initial state value of the battery module and an impact value applied to the battery module;
a data processing unit that executes an impact analysis model of the battery module; and
a data output unit that outputs an analysis result of the battery module.

18. The battery module evaluation system according to claim 17,
further comprising a data storage unit that stores an impact analysis model of the battery module.

19. A method for learning an analysis model of an impact on a battery module, the method comprising the steps of:

sampling an initial state value of the battery module and a deformed state value of the battery module according to an impact value applied to the battery module;
repeating the sampling step during a predetermined test period to acquire learning data; and
receiving input of the initial state value of the battery module and the impact value applied to the battery module by the number of times of sampling and machine learning an impact analysis model of a battery module so as to predict an analysis result of the battery module due to an impact.

20. The method for learning an analysis model of an impact on a battery module according to claim 19, wherein:
the sampling step comprises:

measuring an initial state value of the battery module and storing it;
storing an impact value applied to the battery module; and
measuring a deformed state value of the battery module due to the impact and storing it.

21. The method for learning an analysis model of an impact on a battery module according to claim 19, wherein:
the machine learning step comprises calculating a strain of the b0attery module from the deformed state value of the battery module and storing it.

22. The method for learning an analysis model of an impact on a battery module according to claim 19, wherein:
the initial state value of the battery module is an initial state value of a predetermined portion of the battery module, and the deformed state value of the battery module is a deformed state value of a predetermined portion of the battery module.

23. The method for learning an analysis model of an impact on a battery module according to claim 21, wherein:
the strain of the battery module is a plastic strain of the battery module due to the impact.

24. The method for learning an analysis model of an impact on a battery module according to claim 21, wherein:
the strain of the battery module is a strain of a predetermined portion of the battery module.

25. The method for learning an analysis model of an impact on a battery module according to claim 23, wherein:

the strain ($\varepsilon_p$) of the battery module is a value obtained by subtracting the elastic strain ($\varepsilon_e$) from the total strain ($\varepsilon$) at the time of impact of the battery module, and follows the following Mathematical Equations 1 to 3,

$$[\text{Mathematical Equation 1}] \quad \varepsilon_p = \varepsilon - \varepsilon_e$$

$$[\text{Mathematical Equation 2}] \quad \varepsilon = \int_{L_0}^{L} \frac{dL}{L} = \ln\left(\frac{L}{L_0}\right)$$

$$[\text{Mathematical Equation 3}] \quad \varepsilon_e = \sigma/E$$

wherein, $L_0$ is a dimension of the battery module before deformation, $L$ is a dimension of the battery module after deformation, $\sigma$ is a stress value when a material of the battery module is in its elastic limit state, and $E$ is an elastic modulus of the material.

26. The method for learning an analysis model of an impact on a battery module according to claim 21, wherein:
the machine learning step further comprises calculating a SCORE indicating the danger degree of the battery module from the strain of the battery module and storing it.

27. The method for learning an analysis model of an impact on a battery module according to claim 26, wherein:

the SCORE indicating the danger degree of the battery module follows the following Mathematical Equation 4,

$$(SCORE) = 1 / (1 + Exp(-645.62\varepsilon_p{}^3 + 312.85\varepsilon_p{}^2 - 61.417\varepsilon_p + 2.9444)) \quad \text{[Mathematical Equation 4]}$$

wherein, the SCORE is a value between 0 and 1.

28. The method for learning an analysis model of an impact on a battery module according to claim 27, wherein:

if the SCORE is less than 0.4, it is determined that the danger degree due to impact of the battery module is "safe",
if the SCORE is greater than 0.6, it is determined that the danger degree due to impact of the battery module is "dangerous", and
if the SCORE is 0.4 or more and 0.6 or less, determination of the danger degree due to impact of the battery module is reserved.

29. The method for learning an analysis model of an impact on a battery module according to claim 19, wherein:

the initial state value of the battery module includes an initial value of the dimension of the battery module, and the deformed state value of the battery module includes the dimension value of the battery module after deformation.

30. The method for learning an analysis model of an impact on a battery module according to claim 29, wherein:
the dimension value of the battery module includes at least one of the length, width, height, upper face thickness, lower face thickness, and side face thickness of a predetermined portion of the battery module.

31. The method for learning an analysis model of an impact on a battery module according to claim 29, wherein:
the initial state value of the battery module includes at least one of the density of the battery cells included in the battery module and the mass of the battery cells.

32. The method for learning an analysis model of an impact on a battery module according to claim 19, wherein:
the impact value applied to the battery module includes at least one of an impact size and a duration during which the impact is applied.

33. The method for learning an analysis model of an impact on a battery module according to claim 32, wherein:
the impact size is expressed by the acceleration of the object that applies impact to the battery module.

34. The method for learning an analysis model of an impact on a battery module according to claim 19,

further comprising verifying effectiveness of the impact analysis of the battery module,
wherein the verifying effectiveness comprises:

generating, as verification data, an initial state value of the battery module and a deformed state value of the battery module according to an impact value applied to the battery module during a predetermined verification period;
calculating an analysis result of the battery module from an impact analysis model of the battery module using the verification data;
calculating an analysis result of the battery module according to the initial state value of the battery module and the impact value applied to the battery module using the verification data through finite element analysis; and
determining that the impact analysis model of the battery module is valid, when the difference between the analysis result of the battery module predicted from the impact analysis model of the battery module and the analysis result of the battery module calculated through the finite element analysis is within a predetermined reference value range.

【FIG. 1】

FIG. 2

```
┌─────────────────────────────────────────────┐
│       Sampling an initial state value and a deformed    │
│    state value of the battery module according to an    │──S110
│       impact value applied to the battery module        │
└─────────────────────────────────────────────┘
                        │
                        ▼
┌─────────────────────────────────────────────┐
│         Repeating the sampling step S110 during         │
│   a predetermined test period to acquire learning data  │──S120
└─────────────────────────────────────────────┘
                        │
                        ▼
┌───────────────────────────────────────────────────┐
│  ┌─────────────────────────────────────────────┐  │
│  │    Calculating a strain of the battery module from the   │──S131
│  │  deformed state value of the battery module and storing it │  │
│  └─────────────────────────────────────────────┘  │──S130
│                        │                          │
│                        ▼                          │
│  ┌─────────────────────────────────────────────┐  │
│  │  Calculating a SCORE indicating the danger degree of the │  │
│  │  battery module from the strain of the battery module    │──S132
│  │                    and storing it                        │  │
│  └─────────────────────────────────────────────┘  │
└───────────────────────────────────────────────────┘
                        │
                        ▼
┌─────────────────────────────────────────────┐
│           Verifying effectiveness of the impact analysis │──S140
│                    of the battery module                 │
└─────────────────────────────────────────────┘
```

FIG. 3

| Inputing the initial state value of the battery module and the impact value applied to the battery module | ~S210 |

Predicting the deformed state value of the battery module due to impact — S221

— S220

Predicting a strain of the battery module from the deformed state value of the battery module — S222

Predicting a SCORE indicating the danger degree of the battery module from the predicted strain of the battery module — S223

【FIG. 4】

## INTERNATIONAL SEARCH REPORT

| International application No. |
| --- |
| **PCT/KR2023/020092** |

| | |
| --- | --- |
| **A.** | **CLASSIFICATION OF SUBJECT MATTER** |

**G06N 20/00**(2019.01)i; **H01M 10/42**(2006.01)i; **H01M 50/242**(2021.01)i

According to International Patent Classification (IPC) or to both national classification and IPC

| | |
| --- | --- |
| **B.** | **FIELDS SEARCHED** |

Minimum documentation searched (classification system followed by classification symbols)

G06N 20/00(2019.01); G01R 31/367(2019.01); G01R 31/382(2019.01); G06T 7/00(2006.01); G06T 7/60(2006.01); G16C 10/00(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충격(collision), 기계 학습 모델(machine learning model), 변형율 (deformation degree), 예측(prediction)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| X<br><br>Y | JP 2021-060229 A (GS YUASA CORP.) 15 April 2021 (2021-04-15)<br>See paragraphs [0045], [0058], [0068], [0072], [0079] and [0091]. | 1,13-18<br><br>2-12,19-34 |
| Y | CN 111105403 A (SHANTOU UNIVERSITY) 05 May 2020 (2020-05-05)<br>See paragraphs [0035], [0040]-[0044], [0071] and [0095]; claim 1; and figure 5. | 2-12,19-34 |
| A | KR 10-2354112 B1 (SOGANG UNIVERSITY RESEARCH & BUSINESS DEVELOPMENT FOUNDATION) 24 January 2022 (2022-01-24)<br>See paragraphs [0009]-[0014]. | 1-34 |
| A | KR 10-2108279 B1 (SAMSUNG SDI CO., LTD.) 07 May 2020 (2020-05-07)<br>See claim 1. | 1-34 |

☑ Further documents are listed in the continuation of Box C.      ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **07 March 2024** | **07 March 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2023/020092**

| C. | DOCUMENTS CONSIDERED TO BE RELEVANT | |
|---|---|---|
| Category* | Citation of document, with indication, where appropriate, of the relevant passages | Relevant to claim No. |
| A | KR 10-2021-0016154 A (S.J TECH CO., LTD.) 15 February 2021 (2021-02-15)<br>See claims 1-2. | 1-34 |

Form PCT/ISA/210 (second sheet) (July 2022)

INTERNATIONAL SEARCH REPORT
Information on patent family members

International application No.

**PCT/KR2023/020092**

| Patent document cited in search report | | | Publication date (day/month/year) | Patent family member(s) | | | Publication date (day/month/year) |
|---|---|---|---|---|---|---|---|
| JP | 2021-060229 | A | 15 April 2021 | None | | | |
| CN | 111105403 | A | 05 May 2020 | None | | | |
| KR | 10-2354112 | B1 | 24 January 2022 | KR | 10-2020-0119383 | A | 20 October 2020 |
| KR | 10-2108279 | B1 | 07 May 2020 | KR | 10-2014-0137181 | A | 02 December 2014 |
| | | | | US | 2014-0351177 | A1 | 27 November 2014 |
| | | | | US | 9477931 | B2 | 25 October 2016 |
| KR | 10-2021-0016154 | A | 15 February 2021 | KR | 10-2238248 | B1 | 12 April 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220174030